# EUROPÄISCHE PATENTANMELDUNG

(11) **EP 3 301 710 A1**
(43) Veröffentlichungstag der Anmeldung: **04.04.2018**
(21) Anmeldenummer: 16191443.7
(22) Anmeldetag: 29.09.2016
(51) Int. Cl.: H01L 23/36, H01L 23/367

(54) **WÄRMELEITENDER ISOLATOR**

(71) Anmelder: Siemens Aktiengesellschaft, 80333 München (DE)
(72) Erfinder: Meyer, Angelo, 90489 Nürnberg (DE); Neugebauer, Stephan, 91058 Erlangen (DE)

(57) **Zusammenfassung**

Die Erfindung betrifft einen wärmeleitenden Isolator (1). Zur Verbesserung seines Wärmeleitvermögens wird vorgeschlagen, den wärmeleitender Isolator (1) mit einen ersten Teil (10) mit ersten Lamellen (11), die an mindestens einer Oberfläche des ersten Teils (10) angeordnet sind, und einen zweiten Teil (20) mit zweiten Lamellen (21), die an mindestens einer Oberfläche des zweiten Teils (20) angeordnet sind, auszustatten. Dabei sind die ersten Lamellen (11) und die zweiten Lamellen (21) ineinander greifend angeordnet, wobei zwischen dem ersten Teil (10) und dem zweiten Teil (20) zumindest im Bereich der Lamellen (11,21) eine Isolationsschicht (30) angeordnet ist. Die Erfindung betrifft weiter eine Kühlanordnung (2) mit mindestens einem solchen wärmeleitenden Isolator, wobei der erste Teil (10) mit einer Wärmequelle (41) und der zweite Teil (20) mit einer Wärmesenke (42) verbunden ist.

## Beschreibung

Die Erfindung betrifft einen wärmeleitenden Isolator. Weiter betrifft die Erfindung eine Kühlanordnung mit mindestens einem solchen wärmeleitenden Isolator.

In elektrischen Leitern und Bauelementen, insbesondere an Leistungshalbleitern, sowie an deren Kontaktstellen wird elektrische Energie in Verlustleitung und damit in Wärme umgewandelt. Diese Wärme muss abgeführt werden, um ein Überhitzen des Leiters oder Bauelements bzw. das Entstehen unzulässig hoher Temperaturen zu verhindern.

Befinden sich zu entwärmende Leiter, wie beispielsweise eine Stromschiene, und eine zur Verfügung stehende Wärmesenke, wie beispielsweise ein Kühlkörper, auf unterschiedlichem elektrischen Potential und sind beide elektrisch leitfähig, so muss der Isolator elektrisch hinreichend isolierend sein. Für eine gute Entwärmung ist darüber hinaus eine gute thermische Leitfähigkeit hilfreich.

Dabei sind jedoch kaum Materialien bekannt, die in gleichem Maße über eine gute Wärmeleitfähigkeit, wie auch über gute elektrische Isolationseigenschaften verfügen. In diesem Bereich herausragend sind Keramiken, die jedoch aufgrund ihrer Sprödigkeit oftmals nicht ohne weiteres einsetzbar sind. Besser geeignet wären hierfür Kunststoffe, die jedoch meist über eine relativ schlechte Wärmeleitfähigkeit verfügen.

Zusätzlich zur Entwärmung müssen fast alle mechanischen Bauteile an einer Tragstruktur mechanisch befestigt werden und somit Kräfte aufnehmen können ohne dadurch in Gefahr zu geraten, beschädigt zu werden.

Üblicherweise werden daher heutzutage elektrische Bauteile auf unterschiedlichen Potenzialen planar über relativ schlecht wärmeleitende Bauteile verbunden.

Ist ein großes Maß an Kühlung vonnöten, so wird oftmals auf konvektive, fluide Entwärmung, beispielsweise mittels Luft oder Wasser zurückgegriffen.

Der Erfindung liegt die Aufgabe zugrunde, einen Isolator hinsichtlich seines Wärmeleitvermögens zu verbessern.

Die Aufgabe wird durch einen wärmeleitenden Isolator aufweisend, einen ersten Teil mit ersten Lamellen, die an mindestens einer Oberfläche des ersten Teils angeordnet sind, und einen zweiten Teil mit zweiten Lamellen, die an mindestens einer Oberfläche des zweiten Teils angeordnet sind, gelöst, wobei die ersten Lamellen und die zweiten Lamellen ineinander greifend angeordnet sind, wobei zwischen dem ersten Teil und dem zweiten Teil zumindest im Bereich der Lamellen eine Isolationsschicht angeordnet ist. Weiter wird die Aufgabe durch eine Kühlanordnung mit mindestens einem solchen wärmeleitenden Isolator gelöst, wobei der erste Teil mit einer Wärmequelle und der zweite Teil mit einer Wärmesenke verbunden ist.

Vorteilhafte Ausgestaltungen der Erfindung sind in den abhängigen Ansprüchen angegeben.

Der Erfindung liegt die Erkenntnis zugrunde, dass sich die Wärmeleitfähigkeit dadurch erheblich verbessern lässt, dass sich die Isolationsschicht zur elektrischen Isolation über eine große Fläche erstreckt und sich der Wärmeübergang auf diese Fläche verteilt. Geometrisch ist der Isolator vorteilhafterweise so gestaltet, dass die an der erste Teil und der zweite Teil des Isolators mit ihren Lamellen ineinander verschränkt angeordnet sind. Hierdurch lässt sich eine im Vergleich zum planaren Kontaktierung eine deutlich größere Oberfläche für einen Wärmeübergang verwenden. Weiterhin werden bei form- oder stoffschlüssigen Verbindungen wesentlich höhere mechanische Festigkeiten beim Isolator erreicht, als mit geringerer Fläche.

Die Verschränkung, das heißt das kammartige Ausbildung des ersten und des zweiten Teils, die ineinander greifen, kann durch gerade ausgerichtete Lamellen erfolgen. Alternativ oder über einen Abschnitt sind auch andere Geometrien, wie beispielsweise konzentrische Kreise etc., möglich. Letztere würden abweichende mechanische Belastbarkeiten ergeben.

Durch ein unterschiedlich tiefes Einstecken der Lamellen ineinander können aus gleichen Grundkomponenten unterschiedliche Isolatorlängen erzeugt werden. Dies ist sowohl bei einem Verguss, wie auch bei einem Verpressen des ersten und des zweiten Teils miteinander möglich.

Als besonders vorteilhaft hat es sich erwiesen, wenn zwischen dem ersten Teil und dem zweiten Teil ein elektrisches Funktionsbauteil angeordnet ist. Eine solche Integration eines elektrischen Funktionsbauteils zwischen die leitenden Komponenten ist beispielsweise für Kondensatoren, Widerstände oder Temperatursensoren mit optischer- oder Funkkopplung möglich. Hiermit lässt sich ein besonders kompakter Aufbau erzielen. Gleichzeitig erhöhen diese Funktionsbauteile die Wärmeleitfähigkeit zwischen erstem Teil und zweitem Teil und verbessern somit das Wärmeleitvermögen des Isolators bei gleichzeitiger Erweiterung der Funktion des Isolators.

Dieser Aufbau weist eine Vielzahl von Vorteilen auf. Es werden unterschiedliche Funktionen wie beispielsweise Wärmeübertrag, mechanische Fixierung, Schwingungsdämpfung, Toleranzausgleich gleichzeitig durch nur ein Bauteil. Der Wärmeübergang ist dabei wesentlich höher als bei einer planaren Verbindung. Ebenso ist die mechanische Festigkeit höher. Durch die Gestaltung des Isolators sind dünne Schichten des schlecht thermisch leitfähigen Isoliermaterials in der Isolierschicht möglich und es können dabei hohe elektrische Spannungen anliegen.

Es werden keine zusätzlichen, isolierenden Bauteile zur Befestigung mehr benötigt, da die Komponenten des Isolators bereits fest miteinander verbunden sind. Der Isolator selbst kann robust ausgeführt werden. Dann besteht auch bei der Montage keine Bruchgefahr, wie beispielsweise bei zwischengelegten Isolierplättchen aus Keramik.

Im Gegensatz zu einer Fluidkühlung wird zusätzlich eine mechanische Haltefunktion gewährleistet. Durch die große Oberfläche können auch eher weiche Isolierstoffe zum Einsatz kommen.

Im Fall des Einsatzes einer Kühlanordnung für eine Stromschienenkühlung werden wesentlich höhere Ströme bei gleichem Schienenquerschnitt ermöglicht. Dies führt zu einer deutlichen Platz-, Material- und Kostenersparnis. Somit werden, insbesondere bei wassergekühlten Geräten, höhere Leistungsdichten möglich.

Bei einer vorteilhaften Ausgestaltung der Erfindung sind der erste Teil und/oder der zweite Teil aus Metall. Metall wie beispielsweise Kupfer oder Aluminium hat sich zur Herstellung von Kühlkörpern mit einer hohen Wärmeleitfähigkeit bewährt. Daher hat es sich als vorteilhaft erwiesen, ein Metall für die Herstellung des ersten Teils und/oder des zweiten Teils zu verwenden. Somit besteht dann der erste Teil und/oder der zweite Teil jeweils aus Metall. Die isolierende Eigenschaft wird dann alleine durch die Isolationsschicht erreicht.

Es können dabei unterschiedliche Werkstoffe für die leitenden Teile, das heißt den ersten und den zweiten Teil verwendet werden, um unter anderem das Kosten-Nutzen-Verhältnis des Isolators zu verbessern. So hat sich für die Seite, die für den Anschluss der Wärmequelle vorgesehen ist, die Verwendung von Kupfer als besonders vorteilhaft erwiesen, um einen guten Wärmetransport zu gewährleisten. Der zweite Teil, der beispielsweise bei Fräsbearbeitung einen großen Materialverlust bedingt, könnte aus Aluminium hergestellt werden. Durch die Trennung mit einem Isolierstoff wird hierbei die Bildung eines elektrochemischen Elements, das Korrosion verursachen kann, zuverlässig unterbunden.

Die elektrisch leitenden Komponenten des ersten und des zweiten Teils haben bei der Verwendung von elektrisch leitfähigen Materialien bei erstem und zweitem Teil zueinander einen definierten Abstand, um die benötigte Isolierstrecke einzuhalten. Der Mindestabstand ist von der zu isolierenden Spannung und dem Isoliermaterial der Isolationsschicht abhängig.

Die einzelnen Komponenten des Isolators sind miteinander form-, kraft- oder stoffschlüssig verbunden, um die geforderte mechanische Haltefunktion bereitzustellen. Die Verbindung kann beispielsweise durch ein Aushärten einer Komponente, wie beispielsweise einem Isolierstoff, ein zusätzliches Lot oder einem zusätzlichen Kleber, oder ein Verpressen des Verbunds hergestellt werden.

Bei einer weiteren vorteilhaften Ausgestaltung der Erfindung umfassen die ersten Lamellen und/oder die zweiten Lamellen jeweils weitere Lamellen. Der Vorteil dieser weiteren Lamellen liegt darin, die Oberfläche für den Wärmeübergang zwischen dem ersten Teil und dem zweiten Teil weiter zu erhöhen. Durch das Versehen der Lamellen mit weiteren Lamellen entsteht ein sogenanntes Tannenbaumprofil mit zum Teil deutlich vergrößerter Oberfläche. Dies verbessert die thermische Eigenschaften ohne die elektrischen Eigenschaften zu verschlechtern.

Um neben der vorteilhaften Oberflächenvergrößerung auch die Haftung zu vergrößern können auch Einsätze wie Stifte, etc. als Verbindungen zwischen den Komponenten eingebracht werden.

Um die Haftung der einzelnen Komponenten zueinander weiter zu erhöhen oder schlichtweg die Oberfläche zu vergrößern, kann die Oberfläche der Komponenten strukturiert werden, bspw. durch Ätzen, Sandstrahlen, Bürsten, Prägen oder Aufschäumen. Dann weist die Oberfläche der ersten Lamellen und/oder die Oberfläche der zweiten Lamellen zumindest in Teilbereichen eine Strukturierung auf.

Neben der Strukturierung der Oberflächen zwischen dem ersten Teil und dem zweiten Teil des Isolators können auch die zur Wärmequelle bzw. Wärmesenke gerichteten Oberflächen des Isolators strukturiert werden um den Wärmeübergang zwischen Wärmequelle bzw. Wärmesenke und Isolator weiter zu verbessern. Dazu können an dieser Oberfläche trapezförmige, dreieckige oder gerundete Lamellen vorgesehen werden. Wärmequelle bzw. Wärmesenke weisen dann dazu entsprechend korrespondierende Oberflächen auf. Hierdurch erhöht sich die Kontaktoberfläche zwischen Wärmequelle bzw. Wärmesenke und Isolator als im eben, d.h. planar, verbundenen Fall. Dadurch lässt sich sowohl mehr Wärme als auch eine größere mechanische Kraft übertragen.

Der Raum zwischen den elektrisch leitfähigen Teilen ist mit der Isolationsschicht ausgefüllt. Hierzu kann beispielsweise ein Kunststoffinsert (Formteil) oder ein Kunststoffverguss verwendet werden. Als besonders vorteilhaft hat es sich erwiesen, wenn der Kunststoffverguss thermisch leitfähig ist. Dabei ist auch ein Spritzguss möglich. Denkbar ist auch ein Keramikinsert, das eingepresst, geklebt oder gelötet wird sowie ein Glas oder Porzellan. Der Isolierstoff benötigt dabei in der Regel eine gegenüber einem Luftspalt deutlich geringere Dicke, um die elektrischen Potenziale ausreichend voneinander elektrisch zu isolieren.

Es hat sich als besonders vorteilhaft erwiesen, wenn die Enden der Lamellen teilweise zurückgezogen sind. Hierdurch können diese mit dem isolierenden Material der Isolationsschicht abgedeckt werden, womit der geringe Abstand an den Enden nicht mehr zu einer kritischen Luftstrecke wird.

Der Rückzug verringert die Fläche, die zum Wärmeübertrag verwendet werden kann, weshalb er gering ausfallen sollte. Die inneren Lamellen werden vollständig abgedeckt, weshalb sie nur gering zurückgezogen werden müssen. Die äußeren Lamellen werden in einem größeren Rückzug angeordnet, da hier über das Isoliermaterial eine vollständige Luft-, bzw. Kriechstrecke eingehalten wird.

Bei einer weiteren vorteilhaften Ausgestaltung der Erfindung besteht die Isolationsschicht aus einem flexiblen Material. Dadurch werden mechanische Spannungen im Aufbau zwischen einer auf einer Seite des Isolators befestigten Wärmequelle und einer auf einer anderen Seite des Isolators befestigten Wärmesenke zuverlässig verhindert. Die Isolationsschicht kann dabei unterschiedliche Ausdehnungen aufgrund unterschiedlicher Temperatur ausgleichen und so Spannungen im Isolator vermeiden.

Darüber hinaus ist bei der Verwendung von weichen Isoliermaterialien für die Isolationsschicht neben dem Ausgleich kleiner mechanischer Verschiebungen eine Schwingungsdämpfung möglich. Wird ein Verguss eingesetzt, so können die elektrisch leitenden Komponenten zueinander fixiert vergossen werden. Damit können Zielmaße des Isolators eingehalten werden, auch wenn die Einzelkomponenten größere Toleranzen aufweisen.

Bei einer weiteren vorteilhaften Ausgestaltung der Erfindung umfasst der wärmeleitende Isolator einen Wärmepuffer. In einzelne Komponenten des Isolators können Phase-Change-Materialien, auch als PCM bekannt, als Wärmepuffer eingebracht werden. Beispielsweise würde ein auf der Wärmequellenseite eingebrachtes PCM kurzzeitig eingebrachte "Stoßwärme" aufnehmen. Die aufgenommene Wärme könnte dann über einen größeren Zeitraum über einen eher schlecht wärmeleitenden Isolator übertragen werden. Darüber hinaus ist auch die Integration eines PCM in den Isolierstoff möglich. Eine Überhitzung, auch wenn diese nur lokal auftritt, kann dadurch zuverlässig vermieden werden.

Bei einer weiteren vorteilhaften Ausgestaltung der Erfindung ist die Wärmesenke als Kühlkörper, insbesondere als Heatpipekühlkörper, ausgebildet. Hiermit ist es möglich, insbesondere bei der Verwendung von Heatpipes oder Heatdiffusern, einen effizienten Wärmetransport auch über längere Entfernungen zu ermöglichen.

Im Folgenden wird die Erfindung anhand der in den Figuren dargestellten Ausführungsbeispiele näher beschrieben und erläutert. Es zeigen:

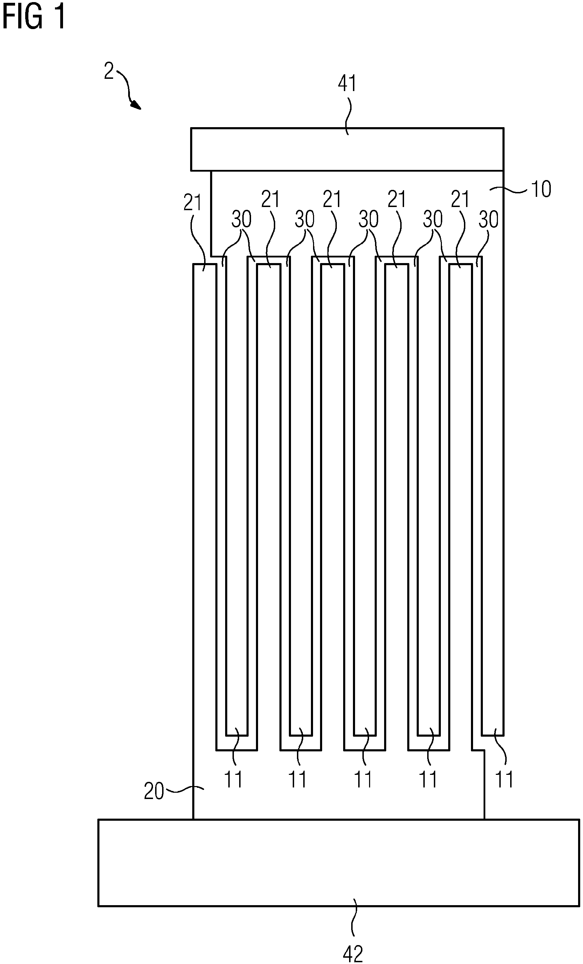

- FIG 1 bis FIG 3: Ausführungsbeispiele eines wärmeleitenden Isolators.

Die FIG 1 zeigt eine zweidimensionale Sicht auf eine Kühlanordnung 2. Die Kühlanordnung 2 umfasst einen wärmeleitenden Isolator 1, eine Wärmequelle 41 und eine Wärmesenke 42. Wärmequelle 41 und Wärmesenke sind mittels des wärmeleitenden Isolators 1 elektrisch voneinander isoliert, da diese im Betrieb häufig unterschiedliche elektrische Potentiale besitzen. Dies ist beispielsweise dann der Fall, wenn eine Stromschiene an einem Kühlkörper mittels des wärmeleitenden Isolators 1 befestigt ist.

Für die isolierende Eigenschaft ist zwischen ersten Lamellen 11 eines ersten Teils 10 des wärmeleitenden Isolators 1 und zweiten Lamellen 21 eines zweiten Teils 20 des wärmeleitenden Isolators 1 eine Isolationsschicht 30 angeordnet, die elektrisch nicht oder nur sehr gering leitfähig ist. Die ersten Lamellen 11 und zweiten Lamellen 21 sind so ausgeformt, dass diese ineinander greifen und dazwischen eine für die elektrische Isolation hinreichende Isolationsschicht 30 aufnehmen können. Durch die Lamellen 11,21 vergrößert sich die Oberfläche zwischen erstem Teil und zweitem Teil. Dies beeinflusst die Wärmeleitfähigkeit von dem ersten Teil zum zweiten Teil dahingehend, dass sich diese deutlich verbessert. Insbesondere ist die Verbesserung dann gegeben, wenn das Material der Isolationsschicht 30 eher schlechte Wärmeleitfähigkeit aufweist, wie es bei Stoffen, die eine elektrisch isolierende Wirkung haben, häufig auftritt.

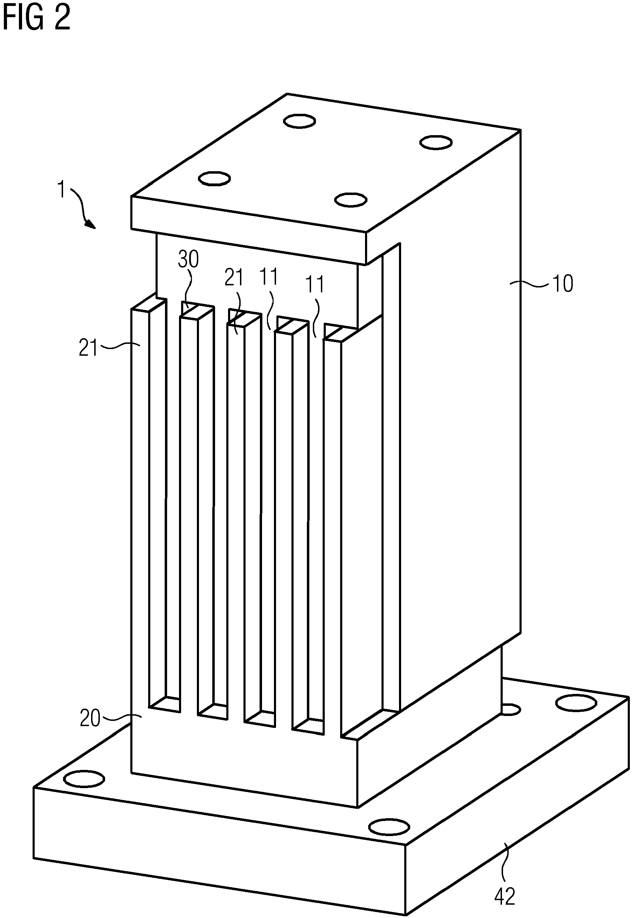

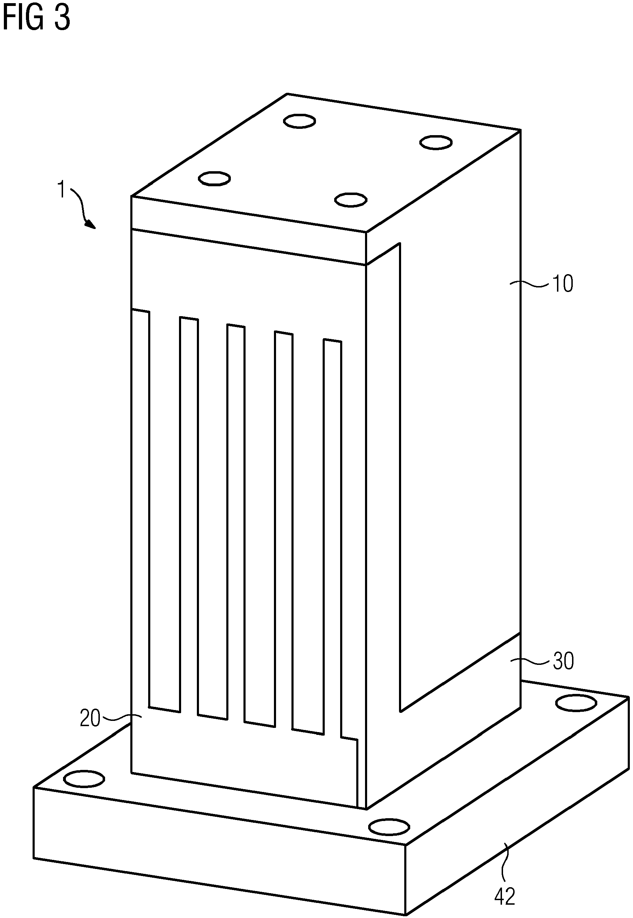

FIG 2 zeigt eine dreidimensionale Darstellung der Kühlanordnung 2. Auf die Darstellung der Wärmequelle wurde verzichtet. Zur Vermeidung von Wiederholungen wird auf die Beschreibung zur FIG 1 und die dort eingeführten Bezugszeichen verwiesen. Bei dieser Ausführungsform sind die Enden der dargestellten Lamellen teilweise zurückgezogen. Dadurch können diese gerade im Randbereich besser mit isolierendem Material, beispielsweise dem Material der Isolierschicht 30, abgedeckt werden. In entsprechendes Beispiel zeigt FIG 3. Damit wird die Ausbildung kritischer Luftstrecken zuverlässig verhindert. Da dieser Rückzug nicht zur Vergrößerung der für den Wärmeübergang wirksamen Oberfläche beiträgt, sollte der Rückzug klein (<10%) gewählt werden.

Zusammenfassend betrifft die Erfindung einen wärmeleitenden Isolator. Zur Verbesserung seines Wärmeleitvermögens wird vorgeschlagen, den wärmeleitender Isolator mit einen ersten Teil mit ersten Lamellen, die an mindestens einer Oberfläche des ersten Teils angeordnet sind, und einen zweiten Teil mit zweiten Lamellen, die an mindestens einer Oberfläche des zweiten Teils angeordnet sind, auszustatten. Dabei sind die ersten Lamellen und die zweiten Lamellen ineinander greifend angeordnet, wobei zwischen dem ersten Teil und dem zweiten Teil zumindest im Bereich der Lamellen eine Isolationsschicht angeordnet ist. Die Erfindung betrifft weiter eine Kühlanordnung mit mindestens einem solchen wärmeleitenden Isolator, wobei der erste Teil mit einer Wärmequelle und der zweite Teil mit einer Wärmesenke verbunden ist.

## Patentansprüche

1. Wärmeleitender Isolator (1) aufweisend,
- einen ersten Teil (10) mit ersten Lamellen (11), die an mindestens einer Oberfläche des ersten Teils (10) angeordnet sind, und
- einen zweiten Teil (20) mit zweiten Lamellen (21), die an mindestens einer Oberfläche des zweiten Teils (20) angeordnet sind, wobei die ersten Lamellen (11) und die zweiten Lamellen (21) ineinander greifend angeordnet sind, wobei zwischen dem ersten Teil (10) und dem zweiten Teil (20) zumindest im Bereich der Lamellen (11,21) eine Isolationsschicht (30) angeordnet ist.

2. Wärmeleitender Isolator (1) nach Anspruch 1, wobei der erste Teil (10) und/oder der zweite Teil (20) aus Metall sind.

3. Wärmeleitender Isolator (1) nach einem der Ansprüche 1 oder 2, wobei die ersten Lamellen (11) und/oder die zweiten Lamellen (21) jeweils weitere Lamellen umfassen.

4. Wärmeleitender Isolator (1) nach einem der Ansprüche 1 bis 3, wobei die Isolationsschicht (30) aus einem flexiblen Material besteht.

5. Wärmeleitender Isolator (1) nach einem der Ansprüche 1 bis 4, wobei der wärmeleitende Isolator (1) einen Wärmepuffer umfasst.

6. Kühlanordnung (2) mit mindestens einem wärmeleitenden Isolator nach einem der Ansprüche 1 bis 5, wobei der erste Teil (10) mit einer Wärmequelle (41) und der zweite Teil (20) mit einer Wärmesenke (42) verbunden ist.

7. Kühlanordnung (2) nach Anspruch 6, wobei die Wärmesenke (42) als Kühlkörper, insbesondere als Heatpipekühlkörper, ausgebildet ist.
